# EUROPEAN PATENT APPLICATION

(11) **EP 4 742 528 A1**
(43) Date of publication of application: **13.05.2026**
(21) Application number: 24835760.0
(22) Date of filing: 01.04.2024
(51) Int. Cl.: H03B 28/00

(54) **HIGH-FREQUENCY SIGNAL GENERATING DEVICE**

(30) Priority: 06.07.2023 JP 2023111676
(71) Applicant: Kyosan Electric Mfg. Co., Ltd., Tsurumi-ku, Yokohama-shi Kanagawa 230-0031 (JP)
(72) Inventor: TEI, Unbou, Yokohama-shi, Kanagawa 230-0031 (JP)
(74) Representative: Hoffmann Eitle
(86) International application number: PCT/JP2024/013509
(87) International publication number: WO 2025/009238

(57) **Abstract**

A radio-frequency signal generator according to the present invention includes: (A) a clock signal generation unit that generates a clock signal using harmonic components that are generated by a nonlinear amplifier; (B) a DDS (direct digital synthesizer) that uses the clock signal as a system clock for performing internal processing and generates a frequency signal having a frequency that is set in frequency setting data; and (C) a higher frequency unit that is composed of an inactive frequency multiplier that does not use active elements and that increases the frequency of the frequency signal generated by the DDS. The clock signal is generated by using the harmonic components that are generated by the nonlinear amplifier, an increase in speed is handled by shortening a delay time in a variable function of the frequency, and a high C/N ratio is handled by suppressing a spurious emission and a phase noise.

## Description

### [TECHNICAL FIELD]

The present invention relates to a radio-frequency signal generator in which an output frequency is variable.

### [BACKGROUND ART]

Linear amplifier-type radio-frequency power supplies, which are used in semiconductor manufacturing equipment, liquid crystal panel manufacturing equipment and others, supply radio-frequency signals (RF signals) in VHF to UHF bands (100 MHz to 1 GHz). The radio-frequency power supplies have a radio-frequency signal generator to generate radio-frequency signals (RF signals) with variable frequency.

As radio-frequency signal generators for generating a radio-frequency signal (RF signal) with variable frequency, there are known frequency synthesizers employing a direct digital synthesizer (DDS) (see Patent Literatures 1 and 2).

These frequency synthesizers include a frequency mixer and a phase-locked loop (PLL) circuit that increase the frequency of DDS signals as peripheral devices of the DDS.

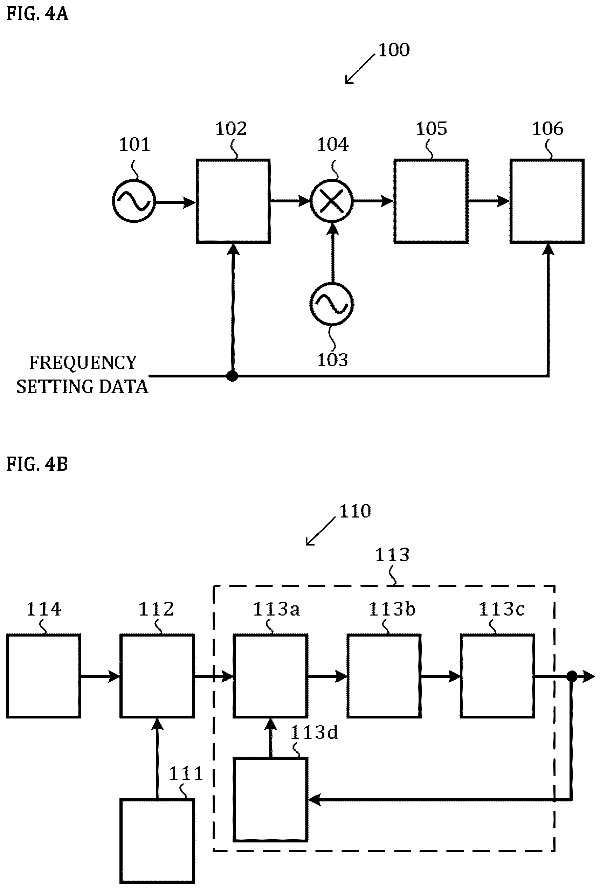

Figure 4A shows a configuration example of a radio-frequency signal generator having a frequency mixer. A radio-frequency signal generator 100 includes a reference signal oscillator 101 that generates a periodic signal at a specific frequency, a DDS 102 that generates a signal at a frequency specified by frequency setting data using the output from the reference signal oscillator 101 as a clock signal, a local oscillator 103 that outputs a local oscillation wave, a mixer 104 that mixes the output signal from the DDS 102 with the local oscillation wave, a multiplier 105 that multiplies a mixed signal produced by the mixer 104, and a frequency divider 106 that divides a signal output from the multiplier 105. A frequency division ratio of the frequency divider 106 is varied on the basis of the frequency setting data to thereby vary an output frequency.

Figure 4B shows a configuration example of a radio-frequency signal generator having a PLL circuit. A radio-frequency signal generator 110 includes a clock signal source 111 that outputs a clock signal, a DDS 112 that generates a signal at the frequency specified by frequency setting data based on the clock signal, a PLL circuit 113 that outputs an oscillation signal at a set frequency on the basis of the frequency of the DDS signal, and a control unit 114 that outputs the frequency setting data. The PLL circuit 113 includes a phase comparator 113a, a loop filter 113b, a voltage control oscillator (VOC) 113c, and a frequency divider 113d.

### [PRIOR ART DOCUMENT]

### [PATENT LITERATURE]

[Patent Literature 1] Japanese Patent Laid-Open Publication No. 2000-124740
[Patent Literature 2] Japanese Patent Laid-Open Publication No. 2022-113497

### [SUMMARY OF THE INVENTION]

### [PROBLEMS TO BE SOLVED BY THE INVENTION]

The radio-frequency signal generators, which is known as a frequency synthesizer, using the conventional DDS for generating a frequency signal with variable frequency have problems, such as a delay time occurring in the PLL circuit and decrease in a carrier-to-noise ratio (C/N ratio) caused by a spurious emission and phase noise generation occurring in the peripheral devices of the DDS and the PLL circuit.

When the frequency is variable, response characteristics of the frequency mixer or the voltage control oscillator (VOC) of the PLL circuit cause a delay in an output signal, and a lock-up time taken to lock a PLL output to a predetermined frequency in a PLL loop becomes approximately 1 ms to several ms.

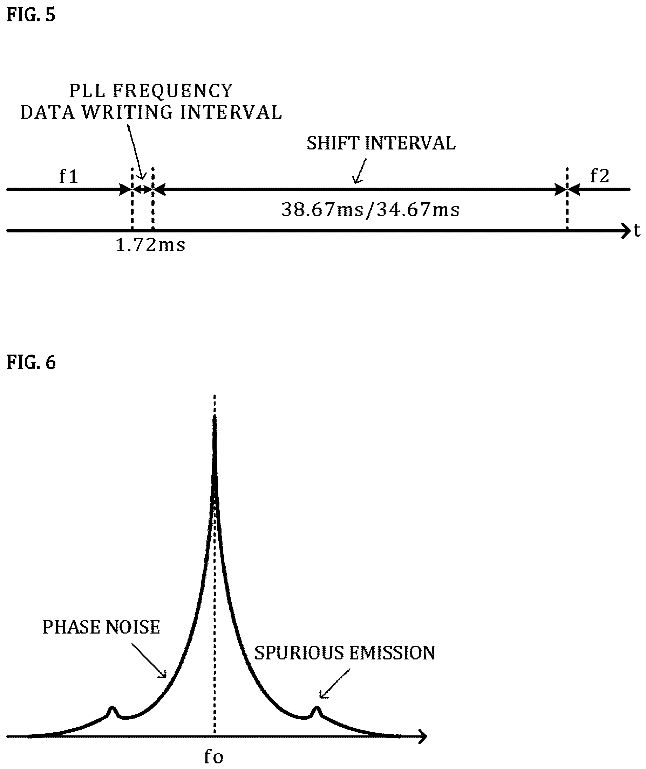

Figure 5 shows an example of a delay time in a radio-frequency signal generator having a PLL circuit. When a frequency is changed from f1 to f2, a writing process of frequency data of a PLL to a DDS is carried out. As an example of such a case, it takes 1.72 ms to write, and the time taken for the frequency to stabilize due to repetitive processing in the PLL loop is 38.67 ms when the frequency is changed from 450 MHz to 460 MHz, and is 34.67 ms when the frequency is changed from 460 MHz to 450 MHz.

Furthermore, due to the circuit elements, such as the frequency mixer and the voltage control oscillator (VOC) of the PLL circuit, the spurious emission and the phase noise cause the decrease in the carrier-to-noise ratio (C/N ratio) of the frequency signal generated by the radio-frequency signal generator.

Figure 6 is a schematic diagram that illustrates the spurious emission and the phase noise. In a case where a modulation signal for modulating the phase of a carrier signal is a periodic signal, a harmonic spurious emission occurs at a frequency that is integer multiple of a fundamental wave. The phase noise occurs in a double sideband of the carrier signal and is expressed as the carrier-to-noise ratio (C/N ratio).

In the field of radio-frequency signal generator, if it is required to generate an output signal with fast and variable frequency and having a high C/N ratio, conventional radio-frequency signal generators have a problem of difficulty in achieving fast frequency and high C/N ratio due to the delay in the lock-up time, the spurious emission, and the phase noise.

An object of the present invention is to solve the above-described existing problems, and to increase the speed by shortening the delay time and to achieve the high C/N ratio by suppressing the spurious emission and the phase noise in the function of varying frequency.

### [MEANS FOR SOLVING THE PROBLEM]

A radio-frequency signal generator of the present invention includes:
(A) a clock signal generation unit configured to generate a clock signal by using harmonic components generated by a nonlinear amplifier;
(B) a direct digital synthesizer (DDS) configured to generate a frequency signal with a frequency set in frequency setting data using the clock signal as a system clock for performing internal processing; and
(C) a higher frequency unit consisting of an inactive frequency multiplier with no active elements and configured to increase the frequency of the frequency signal generated by the DDS.

### (A: Clock signal generation unit)

The radio-frequency signal generator of the present invention uses the clock signal generated by the clock signal generation unit as the system clock for performing the internal processing of the DDS. The clock signal generation unit includes the nonlinear amplifier. The amplifier generates harmonic components for a fundamental wave due to its nonlinearity. The radio-frequency signal generator of the present invention generates a radio-frequency signal using the harmonic components generated by the amplifier, thereby using the radio-frequency signal as a clock signal of the system clock in the DDS.

The clock signal generation unit uses the harmonic components generated by the nonlinear amplifier so that a clock signal with a high C/N ratio (carrier-to-noise ratio) and a low spurious emission can be generated.

The clock signal generation unit includes:
(a) a reference signal oscillator configured to generate a periodic signal at a specific frequency as a reference signal;
(b) a nonlinear amplifier configured to generate harmonic components for a fundamental wave of the reference signal;
(c) a narrowband harmonic filter (first BPF) configured to pass only the harmonic components; and
(d) a radio-frequency amplifier configured to amplify the harmonic components passed through the narrowband harmonic filter, and
   the clock signal generation unit
(e) is configured to generate an output signal from the radio-frequency amplifier as a clock signal.

The nonlinear amplifier is configured to generate harmonic components in addition to a fundamental frequency due to its nonlinearity. The present invention utilizes the harmonic components generated by the nonlinear amplifier to generate a radio-frequency signal to be used as a clock signal. Since frequencies of harmonic components are integral multiple of a fundamental frequency, the frequency signal oscillator generates a radio-frequency signal with high accuracy, if a fundamental frequency of a reference signal of the reference signal oscillator is highly accurate. The nonlinear amplifier may employ a buffer amplifier or class-C amplifier.

### (B: DDS)

The DDS (direct digital synthesizer) is configured to generate a frequency signal of which frequency is set based on frequency setting data. A control unit sets the frequency setting data to the DDS so that the DDS generates the frequency signal at the frequency set based on the frequency setting data. The frequency of the frequency signal can be varied by changing the frequency setting data.

The DDS of the present invention performs processes with the clock signal generated by the clock signal generation unit as a system clock. The DDS is operated on the basis of a clock signal with a high C/N ratio (carrier-to-noise ratio) and a low spurious emission, so that the C/N ratio of an output frequency can be increased.

### (C: Higher frequency unit)

The higher frequency unit is configured to increase the frequency of the frequency signal generated by the DDS so as to generate a radio-frequency signal. The higher frequency unit consists of an inactive frequency multiplier with no active elements. Active multipliers cause a spurious emission as an unnecessary emission and phase noise generation in frequency bands other than the fundamental frequency because of the nonlinearity of the active elements. By contrast, since the inactive frequency multiplier included in the radio-frequency signal generator of the present invention has no active elements, it is possible to suppress the spurious emission and the phase noise generation due to the nonlinearity of the active elements.

The higher frequency unit includes:
(f) a differential output unit configured to generate a differential signal of the frequency signals of the DDS;
(g) an inactive frequency multiplier configured to multiply the frequency of the differential signal; and
(h) a target frequency band filter configured to pass a target frequency component from a multiplication signal thus multiplied, and
   the higher frequency unit is
(i) configured to output the frequency component passed through the target frequency band filter (second BPF) as an output signal.

The differential output unit (f) is configured to generate a signal with the polarity that is inverted with respect to the frequency signal of the DDS and use a difference between these signals as a differential output signal, so that it is possible to enhance noise immunity without reducing a potential difference. The differential output unit may employ a differential amplifier or a harmonic transformer.

Since the inactive frequency multiplier (g) does not have the nonlinearity of the active elements, the spurious emission and the phase noise can be suppressed. The inactive frequency multiplier (g) may employ a rectifier type multiplier consisting of Schottky diodes or rectifier diodes.

The higher frequency unit of the present invention is configured to generate the differential signal from the frequency signals of the DDS, and multiply the frequency of the generated differential signal by the inactive frequency multiplier to achieve higher frequency in stages. The achievement of the higher frequency in stages enables the generation of the radio-frequency signal with the high C/N ratio and a low spurious emissions compared to the achievement of the higher frequency at the DDS stage.

### [EFFECT OF THE INVENTION]

As described above, the radio-frequency signal generator of the present invention can increase the speed by shortening the delay time and achieve the high C/N ratio by suppressing the spurious emission and the phase noise in the function of varying frequency.

### [BRIEF DESCRIPTION OF THE DRAWINGS]

Figure 1 illustrates a configuration example of a radio-frequency signal generator of the present invention;
Figure 2A illustrates a processing time in a DDS;
Figure 2B shows a comparison between an example using the DDS of the present invention and an example using a PLL circuit;
Figure 3 shows an example of a phase noise;
Figure 4A shows a configuration example of a radio-frequency signal generator having a frequency mixer;
Figure 4B shows a configuration example of a radio-frequency signal generator having a PLL circuit;
Figure 5 shows an example of a delay time in the radio-frequency signal generator having the PLL circuit; and
Figure 6 is a schematic diagram that illustrates a spurious emission and a phase noise.

### [BEST MODE FOR CARRYING OUT THE INVENTION]

### (1) Schematic Configuration of Radio-Frequency Signal Generator of the Invention

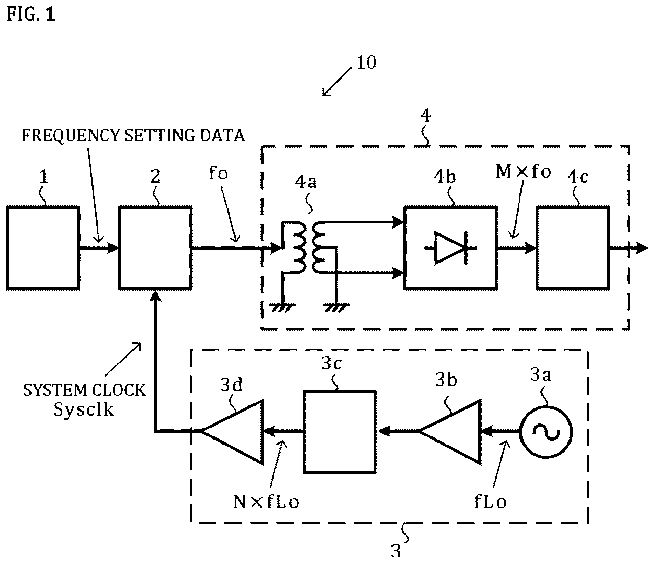

A schematic configuration of a radio-frequency signal generator of the present invention will now be described by referring to FIG. 1.

A radio-frequency signal generator 10 includes a control unit 1, a DDS 2, a clock signal generation unit 3, and a higher frequency unit 4.

The control unit 1 is configured to define frequency setting data that is for setting the frequency of a radio-frequency signal output by the radio-frequency signal generator 10. The frequency of the radio-frequency signal can be varied by changing the frequency setting data.

### (DDS)

The DDS (direct digital synthesizer) 2 is configured to receive the frequency setting data set by the control unit 1 and generate a frequency signal having the frequency set in the frequency setting data.

The DDS 2 is a synthesizer that conducts digital composition to vary a frequency. The DDS 2 linearly increases a sequence of digital states that has generated at a phase accumulator to form a periodic value ramp that represents an instantaneous phase of an output waveform, and applies digital input to a lookup table that determines the amplitude of a sinusoidal wave from phase data so as to convert the value ramp into the sinusoidal wave. The DDS 2 employs a digital/analog convertor so that a desired analog output is output after filtering. The DDS is subjected to digital processing on the basis of a system clock generated from an external reference clock.

The clock signal generation unit 3 is configured to generate a clock signal that is used as a system clock in the DDS 2. The higher frequency unit 4 is configured to increase the frequency of the frequency signal generated by the DDS 2 to a predetermined high frequency level.

### (Clock signal generation unit)

The clock signal generated by the clock signal generation unit 3 is used as a system clock for performing internal processing in the DDS 2.

The clock signal generation unit 3 of the present invention includes an amplifier having nonlinearity. Due to this nonlinearity, the amplifier generates harmonic components with respect to a fundamental wave. The radio-frequency signal generator 10 of the present invention generates a radio-frequency signal by using the harmonic components generated by the amplifier, and uses the radio-frequency signal as a clock signal of the system clock in the DDS 2.

The clock signal generation unit 3 uses the amplifier not as means for amplifying a signal, but as means for generating a radio-frequency signal. The DDS 2 is operated by a clock signal with a high C/N ratio (carrier-to-noise ratio) and a low spurious emission, so that the C/N ratio of an output frequency can be increased.

In this way, the radio-frequency signal generator 10 of the present invention uses the harmonic components generated by the amplifier having nonlinearity to generate the clock signal with the high C/N ratio (carrier-to-noise ratio) and a low spurious emission.

The clock signal generation unit 3 includes:
(a) a reference signal oscillator 3a configured to generate a periodic signal at a specified frequency as a reference signal;
(b) a nonlinear amplifier 3b configured to generate harmonic components with respect to a fundamental wave of the reference signal of the reference signal oscillator 3a;
(c) a narrowband harmonic filter (first BPF) 3c configured to pass only the harmonic components generated by the nonlinear amplifier 3b; and
(d) a radio-frequency amplifier 3d configured to amplify the harmonic components passed through the narrowband harmonic filter 3c, and
   the clock signal generation unit 3 is
(e) configured to generate an output signal in the radio-frequency amplifier 3d as a clock signal.

The nonlinear amplifier 3b is configured to generate harmonic components in addition to a fundamental frequency due to its nonlinearity. The harmonic components generated by the nonlinear amplifier 3b are utilized to generate a radio-frequency signal to be used for a clock signal. Since frequencies of the harmonic components are integral multiple of the fundamental frequency, the radio-frequency amplifier 3d generates a radio-frequency signal with high accuracy, if a fundamental frequency of a reference signal of the reference signal oscillator3a is highly accurate. The nonlinear amplifier 3b may employ, for example, a buffer amplifier or class-C amplifier.

An example of the clock signal generation unit 3 will be presented below.

The reference signal oscillator 3a may employ a crystal oscillator or TCXO at 60 MHz, for instance. The nonlinear amplifier 3b amplifies a reference signal at 60 MHz to generate harmonic components, frequencies of which are integral multiple of the fundamental frequency. The TCXO is an abbreviation of temperature-compensated crystal oscillator that is a crystal oscillator equipped with a temperature compensation circuit to suppress frequency fluctuation caused by the changes in ambient temperature.

As an example, the narrowband harmonic filter 3c may employ an LC ladder filter, surface acoustic wave (SAW) filter, or monolithic crystal filter (MCF). In a case where the clock signal is generated by using 10th harmonic components, the narrowband harmonic filter 3c employs a bandpass filter BPF having a center frequency of 600 MHz and bandwidth of ± 1 MHz.

A radio-frequency signal with the center frequency of 600 MHz, which passed through the narrowband harmonic filter 3c, is output as a clock signal Sysclk to be used as a system clock in the DDS 2.

According to sampling theorem, it is required that the relation between an output frequency fo and the clock signal Sysclk of the DDS 2is Sysclk > 2fo. A phase noise component is expressed in 20•log (fo/f_sysclk) dB, and the greater a frequency f_sysclk of the clock signal Sysclk is compared to twice the output frequency fo, the more phase noise and spurious emission are reduced. Furthermore, the DDS 2 does not have a PLL circuit because it is configured to write frequency data to generate the output frequency fo, so that a delay caused by a lock-up time can be prevented.

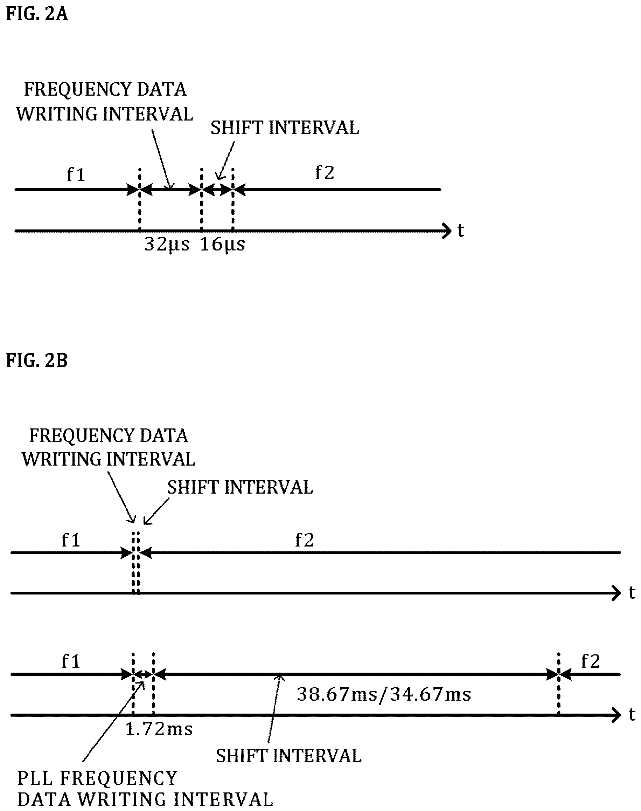

Figure 2A illustrates a processing time in the DDS 2. FIG. 2A shows an example in which an interval required for writing the frequency data is 32 µs (32•10⁻⁶ sec) and a shift interval for changing a frequency on the basis of the frequency data is 16 µs (16•10⁻⁶ sec).

Figure 2B compares an example of using the DDS of the present invention with an example of using a PLL circuit. In FIG. 2B, the upper graph shows an example of using the DDS and the lower example shows an example of using the PLL circuit. Although the example shown by the upper graph in FIG. 2B is the same as that in FIG. 2A, the upper graph of FIG. 2B shows a timescale by scaling down to match a timescale of the PLL circuit.

According to the example of using the PLL circuit, the interval required for writing PLL frequency data is 1.72 ms, and the shift interval for changing a frequency based on the PLL frequency data is 38.67 ms when the frequency is changed from 450 MHz to 460 MHz and 34.67 ms when the frequency is changed from 460 MHz to 450 MHz.

### (Higher frequency unit)

The higher frequency unit 4 consists of an inactive frequency multiplier that does not use active elements and is configured to increase the frequency of the frequency signal generated by the DDS 2.

The higher frequency unit 4 increases the frequency of the frequency signal generated by the DDS 2 to generate a radio-frequency signal. The higher frequency unit 4 consists of the inactive frequency multiplier having no active elements.

In an active frequency multiplier, the nonlinearity of the active elements causes a spurious emission as an unnecessary emission and phase noise generation in frequency bands other than a reference frequency. By contrast, the inactive frequency multiplier included in the radio-frequency signal generator of the present invention has no active elements. Since this multiplier does not have active elements, it is possible to suppress the spurious emission and the phase noise generation due to the nonlinearity of the active elements.

The higher frequency unit 4 includes:
(f) a differential output unit 4a configured to generate a differential signal of a frequency signal in the DDS 2;
(g) an inactive frequency multiplier 4b configured to multiply the frequency of the differential signal in the differential output unit 4a; and
(h) a target frequency band filter 4c configured to pass a target frequency component from the signal multiplied by the inactive frequency multiplier 4b, and the higher frequency unit 4 is
(i) configured to output the frequency component passed through the target frequency band filter (second BPF) 4c as an output signal.

The differential output unit 4a is configured to generate a signal with the polarity that is inverted with respect to the frequency signal in the DDS 2 and use a difference between these signals as a differential output signal. By using the differential output signal, common mode noise can be suppressed without reducing a potential difference to thereby enhance noise immunity. The differential output unit may employ a differential amplifier or harmonic transformer, for instance. FIG. 1 shows a configuration example of using the harmonic transformer as the differential output unit 4a.

Since the inactive frequency multiplier 4b does not have the nonlinearity of the active elements, the spurious emission and the phase noise can be suppressed. The inactive frequency multiplier 4b may employ a rectifier type multiplier consisting of Schottky diodes or rectifier diodes.

The target frequency band filter 4c may employ, as an example, an LC ladder filter, surface acoustic wave (SAW) filter, and the like.

An example of the frequency in the higher frequency unit 4 will be presented below.

The example shows that the system clock Sysclk at a frequency f_sysclk of 1 GSPS (giga sample/second) in the device of the DDS 2 is used to output a radio-frequency signal at a target frequency of 450 MHz.

The control unit 1 sends frequency data at 225 MHz to the DDS 2, and the DDS 2, upon receipt of the frequency data, outputs a sinusoidal signal at 225 MHz. The differential output unit 4a converts the sinusoidal signal at 225 MHz into a differential signal. The target frequency band filter 4c multiplies the differential signal at 225 MHz. In a case where the differential signal is doubled, a radio-frequency signal at 450 MHz is output.

The higher frequency unit 4 of the present invention generates the differential signal from the frequency signal in the DDS 2 and multiplies the frequency of the generated differential signal by means of the inactive frequency multiplier 4b, so that high frequency can be achieved in stages. The achievement of the high frequency in stages enables the generation of the radio-frequency signal with the high C/N ratio and a low spurious emissions compared to the achievement of the high frequency at the DDS stage.

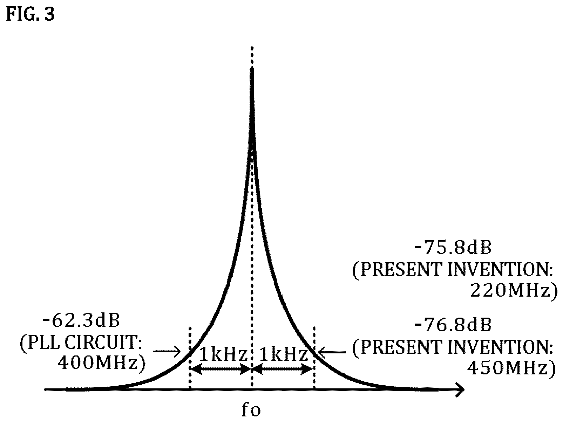

Figure 3 shows an example of the phase noise. FIG. 3 shows the level of the phase noise at ±1 kHz with respect to the output frequency fo.

In the configuration using the PLL circuit, the level of the phase noise at ±1 kHz is -62.3 dB when the output frequency fo is 400 MHz. On the other hand, the level of the phase noise at ±1 kHz in the present invention is -75.8 dB when the output frequency fo is 220 MHz, and the level of the phase noise at ±1kHz is -76.8 dB when the output frequency fo is 450 MHz. This example shows that the level of the phase noise in the radio-frequency signal generator of the present invention exhibits the improvement in the phase noise suppression compared to the configuration using the PLL circuit.

### [INDUSTRIAL APPLICABILITY]

The radio-frequency signal generator of the present invention can be applied to a radio-frequency power supply (RF generator) which is used for a semiconductor manufacturing device, a liquid crystal panel manufacturing device, and others.

### [REFERENCE SIGNS LIST]

- 1: Control Unit
- 2: DDS (Direct Digital Synthesizer)
- 3: Clock Signal Generation Unit
- 3a: Reference Signal Oscillator
- 3b: Nonlinear Amplifier
- 3c: Narrowband Harmonic Filter
- 3d: Radio-Frequency Amplifier
- 4: Higher Frequency Unit
- 4a: Differential Output Unit
- 4b: Inactive Frequency Multiplier
- 4c: Target Frequency Band Filter
- 10: Radio-Frequency Signal Generator
- 100: Radio-Frequency Signal Generator
- 101: Reference Signal Oscillator
- 102: DDS
- 103: Local Oscillator
- 104: Mixer
- 105: Multiplier
- 106: Frequency Divider
- 110: Radio-Frequency Signal Generator
- 111: Clock Signal Source
- 112: DDS
- 113: PLL Circuit
- 113a: Phase Comparator
- 113b: Loop Filter
- 113c: Voltage Control Oscillator (VOC)
- 113d: Frequency Divider
- 114: Control Unit

## Claims

1. A radio-frequency signal generator, comprising:
a clock signal generation unit configured to generate a clock signal using harmonic components generated by an amplifier having nonlinearity;
a direct digital synthesizer (DDS) configured to generate a frequency signal with a frequency set in frequency setting data, using the clock signal as a system clock for performing internal processing; and
a higher frequency unit consisting of an inactive frequency multiplier with no active elements and configured to increase the frequency of the frequency signal generated by the DDS.

2. The radio-frequency signal generator according to claim 1, wherein the clock signal generation unit comprises:
a reference signal oscillator configured to generate a periodic signal at a specified frequency as a reference signal;
a nonlinear amplifier configured to generate harmonic components for a fundamental wave of the reference signal;
a narrowband harmonic filter configured to pass only the harmonic components; and
a radio-frequency amplifier configured to amplify the harmonic components passed through the narrowband harmonic filter, and
the clock signal generation unit is configured to generate an output signal in the radio-frequency amplifier as a clock signal.

3. The radio-frequency signal generator according to claim 1, wherein the higher frequency unit comprises:
a differential output unit configured to generate a differential signal of the frequency signal in the DDS;
an inactive frequency multiplier configured to multiply a frequency of the differential signal; and
a target frequency band filter configured to pass a target frequency component from a multiplication signal thus multiplied, and
the higher frequency unit is configured to use the frequency component passed through the target frequency band filter as an output signal.

4. The radio-frequency signal generator according to claim 1, wherein the clock signal generation unit comprises:
a reference signal oscillator configured to generate a frequency signal at a specified frequency as a reference signal;
a nonlinear amplifier configured to generate harmonic components for a fundamental wave of the reference signal;
a narrowband harmonic filter configured to pass only the harmonic components; and
a radio-frequency amplifier configured to amplify the harmonic components passed through the narrowband harmonic filter, and
the clock signal generation unit is configured to generate an output signal in the radio-frequency amplifier as a clock signal, and
wherein the higher frequency unit comprises:
a differential output unit configured to generate a differential signal of the frequency signal in the DDS;
an inactive frequency multiplier configured to multiply a frequency of the differential signal; and
a target frequency band filter configured to passe a target frequency component from a multiplication signal thus multiplied, and
the higher frequency unit is configured to output the frequency component passed through the target frequency band filter as an output signal.

5. The radio-frequency signal generator according to claim 2 or 4, wherein the nonlinear amplifier is a buffer amplifier or a class-C amplifier.

6. The radio-frequency signal generator according to claim 3 or 4, wherein the differential output unit is a differential amplifier or a harmonic transformer, and
the inactive frequency multiplier is a rectifier type multiplier consisting of Schottky diodes or rectifier diodes.
